Europäisches Patentamt

European Patent Office

Office européen des brevets

(11) Publication number: **0 594 243 A2**

## EUROPEAN PATENT APPLICATION

(21) Application number: 93202875.6

(51) Int. Cl.5: **G11B 5/39, G01R 33/06**

(22) Date of filing: **13.10.93**

(30) Priority: **19.10.92 EP 92203203**

(43) Date of publication of application:
**27.04.94 Bulletin 94/17**

(84) Designated Contracting States:
**DE FR GB**

(71) Applicant: PHILIPS ELECTRONICS N.V.
Groenewoudseweg 1
NL-5621 BA Eindhoven(NL)

(72) Inventor: Folkerts, Wiepke
c/o Int. Octrooibureau B.V.,
Prof. Holstlaan 6
NL-5656 AA Eindhoven(NL)
Inventor: Coehoorn, Reinder
c/o Int. Octrooibureau B.V.,
Prof. Holstlaan 6
NL-5656 AA Eindhoven(NL)
Inventor: Fonken, Adrianus Michael Johannes
Martinus
c/o Int. Octrooibureau B.V.,
Prof. Holstlaan 6
NL-5656 AA Eindhoven(NL)

(74) Representative: Weening, Cornelis et al
INTERNATIONAAL OCTROOIBUREAU B.V.
Prof. Holstlaan 6
NL-5656 AA Eindhoven (NL)

(54) **Magnetic field sensor.**

(57) The invention relates to a magnetic field sensor having a magnetoresistance element, comprising a substrate on which two ferromagnetic layers are provided which exhibit a uniaxial in-plane anisotropy and which are separated by a non-magnetic intermediate layer. In accordance with the invention, the anisotropy direction of one ferromagnetic layer extends transversely with respect to the anisotropy direction of the other ferromagnetic layer. By virtue thereof, it is attained that the change of the direction of magnetization in the sensor caused by external magnetic fields is much more uniform and that the corresponding magnetization curve exhibits a smaller hysteresis. When the sensor is used in a magnetic head, an improved signal/noise ratio is obtained.

The invention relates to a magnetic field sensor having a magnetoresistance element, comprising a substrate to which two ferromagnetic layers are applied which exhibit a uniaxial in-plane anisotropy and which are separated by a non-magnetic intermediate layer. The invention also relates to a magnetic head comprising such a sensor.

Magnetic field sensors are used, *inter alia*, for position and speed of rotation measurements as well as in compasses. Another important application relates to magnetic heads. Such magnetic heads are used for reading information which is magnetically stored on a magnetic recording medium, such as a magnetic tape.

A magnetoresistance element of the above-described construction is known from, *inter alia*, J. Appl. Phys. 69(8), page 4774, 1991. This publication describes, more particularly, a magnetic field sensor comprising a silicon substrate which is coated with a nucleation layer of Ta on which a double structure is provided of, in succession, a first ferromagnetic layer of NiFe (layer thickness 6.2 nm), an intermediate layer of Cu (layer thickness 2.2 nm) and a second ferromagnetic layer of NiFe (layer thickness 4.0 nm) and FeMn (layer thickness 7.0 nm). The known sensor further comprises a capping layer of Ta to minimize oxidation.

The first ferromagnetic layer of NiFe has a uniaxial in-plane anisotropy and a relatively small coercive force, so that the layer has a magnetization curve around zero field strength. The magnetic properties of the second ferromagnetic layer are substantially determined by exchange coupling between the ferromagnetic NiFe and the anti-ferromagnetic MnFe. This causes the magnetization curve of the second, so-called biased, ferromagnetic layer to be shifted towards a field strength having a finite value. Consequently, the magnetization curves of both ferromagnetic layers do not coincide. The second layer also exhibits a uniaxial in-plane anisotropy which is constrained by the anti-ferromagnetic MnFe. The anisotropy directions of both ferromagnetic layers are oriented in parallel, so that, dependent upon the presence and the direction of an externally applied magnetic field, the magnetizations of the layers are parallel or anti-parallel.

For the known layer structure, the change in resistance ($\Delta R/R$) as a function of the applied external field (H) can be measured in a relatively simple manner. Fig. 1 of said publication shows the magnetoresistance curve of such a measurement. It shows two hysteresis curves which have widely differing shapes. The curve corresponding to the reversal of the magnetizations of the "biased" ferromagnetic layer exhibits a relatively high hysteresis of the order of 100 Oe (= 8 kA/m). Due to the above-mentioned exchange coupling with the FeMn layer, said hysteresis has shifted to a field strength of approximately 400 Oe (= 32 kA/m). The other curve around an external field of 0 Oe is governed by the change of magnetization in the "unbiased" NiFe layer. The latter change in magnetization and the change in resistance caused thereby is very important for the use of this type of magnetic field sensors in magnetic heads. Using the known magnetic field sensor, changes in resistance up to 4.1% have been detected at room temperature.

Further investigations conducted by Applicants have shown that, in practice, the hysteresis of the latter magnetoresistance curve is approximately 10 Oe (= 0.8 kA/m). Moreover, it was found that the curve has a rather irregular shape. If said known magnetic field sensor is used, this irregularity causes a relatively high noise level. This adversely affects the signal/noise ratio.

It is an object of the invention to reduce the above-mentioned problems. The invention particularly aims at providing a magnetic field sensor having a hysteresis curve which is substantially free of irregularities and whose hysteresis is considerably smaller than that of the known magnetic field sensor.

These and other objects of the invention are attained by a magnetic field sensor of the type mentioned in the opening paragraph, which is characterized according to the invention in that the anisotropy direction of one of the ferromagnetic layers is oriented transversely with respect to the anisotropy direction of the other ferromagnetic layer.

The invention is based on the insight that due to the parallel orientation of the anisotropy of both ferromagnetic layers, the magnetization reversal in the known magnetic field sensor takes place *via* a domain wall process. Such a reversal causes a more or less step-wise change of the magnetization and of the resistance governed thereby. This phenomenon causes a substantial noise level in the magnetic field sensor. Said noise is commonly referred to as "Barkhausen noise".

If, however, the anisotropy direction of the unbiased NiFe layer extends transversely to the anisotropy direction of the biased NiFe layer, the change of the direction of magnetization of the unbiased NiFe layer takes place under the influence of an external magnetic field, not *via* a domain-wall process but in accordance with a coherent rotation mechanism, resulting in a much lower noise level. Consequently, the magnetoresistance curve has a much more regular shape and also exhibits a lower hysteresis. To obtain useful sensors, the field direction of the applied external field must extend transversely to the anisotropy direction of the unbiased NiFe layer. It is noted that "transverse orientation" is to be understood to mean that the anisotropy directions of both ferromagnetic layers intersect each other at an angle of 90° ± 20°.

It is stressed that the inventive idea of transversely oriented anisotropy directions does not only apply to magnetic field sensors comprising biased and unbiased ferromagnetic layers. The inventive idea can also be used in a magnetic field sensor comprising several ferromagnetic layers having different coercive forces, as is described in the above-mentioned publication. Further, it is stressed that the sensor may comprise more than two ferromagnetic layers. Sensors comprising multilayer structures, based on more than two ferromagnetic layers, have the advantage of a relatively high detection sensitivity.

In principle, any ferromagnetic composition can be used as the material for the ferromagnetic layers. Particularly suitable are the metals Co, Ni and Fe, or alloys thereof. Due to the favourable magnetic properties, magnetic field sensors comprising at least one layer of unbiased NiFe are preferred. NiFe is to be understood to mean herein an alloy of 20 ± 2 at.% of Fe and 80 ± 2 at.% of Ni. This material is soft magnetic and has a very low coercive force and a very low magnetostriction. Moreover, in this material the uniaxial in-plane anisotropy can be realised in a simple manner in an arbitrary orientation by applying the NiFe layer in the presence of a magnetic field having a relatively small strength. The anisotropy caused thereby is parallel to the direction of the applied magnetic field.

If the first ferromagnetic layer consists of unbiased NiFe, for the second ferromagnetic layer doped or undoped Co, Fe and/or Ni can be used. In a first class of sensors the composition of the second layer is selected to be such that it has a coercive force which differs from the coercive force of the first layer. In this case, satisfactory results are obtained if the second ferromagnetic layer consists of an alloy which comprises predominantly Co and Pt.

Better results, however, are obtained with a second class of sensors in which the second layer consists of a biased ferromagnetic layer, preferably biased NiFe. Such a biased NiFe layer can be obtained by applying a layer of MnFe (50 at.% each) to a layer of NiFe. Preferably the thickness of the ferromagnetic layers is not above 10 nm and not below 1.5 nm. If the thickness of the layers exceeds 10 nm, the magnetoresistance effect of the sensor is too small. If the thickness of the layers is less than 1.5 nm, the permeability of the unbiased layer is too small.

The intermediate layer must consist of a non-magnetic material. Said layer serves to magnetically decouple both ferromagnetic layers. Materials which can suitably be used for the intermediate layer are, in particular, metals and metal alloys. It has been found that, in particular, the noble metals, such as Au, Ag, Pt and Cu, can suitably be used for this purpose. The best results are obtained with an intermediate layer of Cu or a Cu alloy. Preferably, the thickness of the intermediate layer is not above 5 nm and not below 1.5 nm. In layers having a thickness below 1.5 nm, insufficient decoupling between both ferromagnetic layers takes place. The "decoupling effect" hardly increases at layer thicknesses in excess of 5 nm.

In the case of the second class of sensors, it has also proved suitable to provide a very thin Co layer, of for example 0.2-0.4 nm, between the ferromagnetic layers and the intermediate layer. As described in the above-mentioned publication, this measure leads to a considerable increase of the magnetoresistance effect.

The ferromagnetic layers can be provided with crossed anisotropy in various ways, dependent upon the type of sensor. In the case of sensors having ferromagnetic layers with different coercive forces, crossed anisotropy can be provided as follows. A first ferromagnetic layer of, for example, unbiased NiFe is provided on a flat surface under the influence of a magnetic field which is oriented parallel to the plane of the substrate. After the intermediate layer has been provided, a second ferromagnetic layer having a higher coercive force is applied. Subsequently, said second layer is magnetized in a relatively strong magnetic field for a short period of time, said field being oriented transversely to the anisotropy direction of the first ferromagnetic layer, and said field extending parallel to the plane of the substrate.

As regards the class of sensors which comprise a first ferromagnetic layer of unbiased NiFe and a second ferromagnetic layer of biased NiFe, crossed anisotropy can be provided as follows. In accordance with a first method a magnetic field can be applied during providing both ferromagnetic layers, which magnetic field must be parallel to the surface of the substrate on which the layers are provided. During the provision of the second ferromagnetic layer the direction of this magnetic field is rotated through approximately 90° about the normal to the substrate surface. In accordance with a second method, it is alternatively possible to provide the ferromagnetic layers in the presence of an in-plane magnetic field which acts in the same direction when both layers are provided. In this case, the anisotropy directions of both ferromagnetic layers are parallel to each other. At a later stage the magnetic field sensor must be heated for a short time and cooled in a magnetic field which extends transversely to the anisotropy direction of the first ferromagnetic layer and which, simultaneously, extends parallel to the substrate surface. This causes the anisotropy direction of the first ferromagnetic layer to be rotated through 90° in the direction of the applied magnetic field. This technique is known under the name of "magnetic annealing". The latter method can also be used if the order of the biased and unbiased ferromagnetic layer on the substrate is reversed.

Embodiments of the magnetic field sensor in accordance with the invention are explained by means of the drawing, in which

Fig. 1 diagrammatically shows a part of a magnetic field sensor in accordance with the present state of the art,

Fig. 2 diagrammatically shows a part of a magnetic field sensor in accordance with the invention,

Fig. 3 shows magnetoresistance curves of a sensor in accordance with the state of the art (a) and in accordance with the invention (b),

Fig. 4 schematically depicts an experimental assembly with which the performance of a magnetic field sensor can be studied.

Fig. 5 diagrammatically shows a magnetic head comprising a magnetic field sensor in accordance with the invention.

It is noted that for clarity not all components shown in the drawing are drawn to scale.

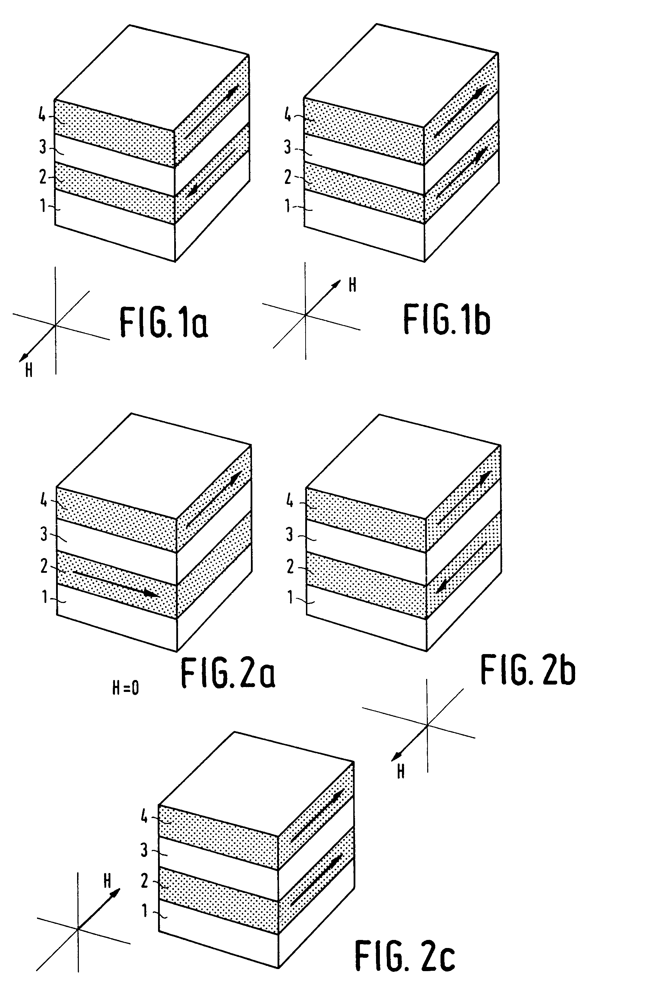

Fig. 1 diagrammatically shows the structure of a known magnetic field sensor. For clarity, only the magnetoresistance material is shown and the electrical connections are omitted. The material shown comprises a non-magnetic substrate 1, for example of Si, on which a first ferromagnetic layer 2, for example of unbiased NiFe, is provided. An intermediate layer 3 of, for example, Cu is applied to layer 2. Said intermediate layer carries a second ferromagnetic layer 4. Said latter layer may consist of a ferromagnetic material whose coercive force differs from that of NiFe, such as a CoPt alloy. In this case it may be advantageous to provide a sub-layer of, for example, Co or NiFe between the CoPt layer and the intermediate layer. However, layer 4 may also consist of a biased NiFe layer. In the latter case, layer 4 consists of a sub-layer of NiFe and a sub-layer of, for example, FeMn, the layer of NiFe being situated between the intermediate layer and the FeMn layer.

The ferromagnetic layers of the known magnetic field sensor are provided in such a manner that they exhibit a uniaxial in-plane anisotropy with parallel orientation. Depending on the method of manufacture, the directions of magnetization of both layers are, in the absence of an external magnetic field, parallel or anti-parallel. If an external magnetic field H is applied, parallel to the direction of magnetization of the sensor, the magnetization of the first ferromagnetic layer will be oriented correspondingly (Fig. 1-a). If the direction of the external magnetic field is reversed, the direction of magnetization of the first layer will also be reversed (Fig. 1-b). Due to the higher coercive force of the second ferromagnetic layer, or the bias effect on said second ferromagnetic layer, the direction of magnetization of said layer will only be reversed when much larger external fields are applied.

Fig. 2 shows a part of a magnetic field sensor in accordance with the present invention. The build-up of the layers is identical to that of the sensor shown in Fig. 1. Both ferromagnetic layers exhibit a uniaxial in-plane anisotropy. The anisotropy direction of the first layer extends transversely with respect to the anisotropy direction of the second layer.

In the absence of an external magnetic field (H = 0) the magnetization of the first ferromagnetic layer extends transversely to the magnetization of the second ferromagnetic layer. Said orientations are imposed by the anisotropies of said layers which are directed so as to be at an angle of approximately 90 degrees with respect to each other. This situation is shown in Fig. 2-a. When a magnetic field H is applied parallel to the magnetization of layer 4, the magnetization of layer 2 is rotated in the direction of the applied field. Depending on the direction of the applied field, the magnetization of the ferromagnetic layer 2 is directed parallel (Fig. 2-c) or anti-parallel (Fig. 2-b) to the magnetization of layer 4.

The phenomenon that the rotation of the magnetization in layer 2 takes place according to a mechanism which differs from that of the known sensor is fundamental to the operation of the magnetic field sensor in accordance with the invention. In the sensor of Fig. 1, the reversal takes place through shifting magnetic domain walls. This is accompanied by jerk changes of the direction of magnetization. In the inventive sensor of Fig. 2, rotation takes place *via* a (coherent) rotation mechanism. This process is accompanied by a much more uniform change of the direction of magnetization.

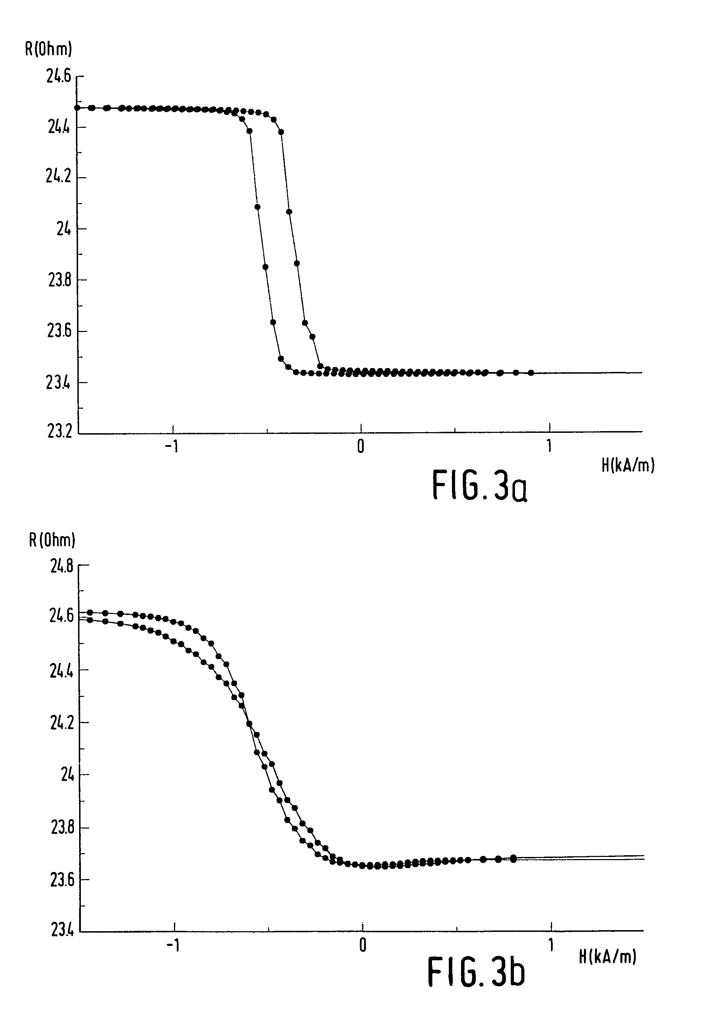

Fig. 3 shows two magnetoresistance curves, measured on a magnetic field sensor in accordance with the state of the art (Fig. 3-a) and in accordance with the invention (Fig. 3-b).

Both magnetic field sensors were manufactured as follows. A silicon substrate was successively provided with a layer of Ta (3 nm), NiFe (8 nm), Cu (2.5 nm), NiFe (6 nm), FeMn (8 nm) and Ta (2 nm) by DC magnetron sputtering. Said layers were provided at a basic pressure of 5.10-7 torr and an Ar-sputtering pressure of 7.10-3 torr. During the sputtering of the first NiFe layer and the second NiFe layer with the FeMn layer, a magnetic field having a strength of approximately 150 Oe (= 12 kA/m) was applied in the plane of the layers. In the manufacture of the known magnetic sensor the orientation of the magnetic field was identical during the sputtering of said layers. Due to this, a sensor was obtained in which the in-plane anisotropy directions of both ferromagnetic layers were oriented parallel to each other. In the manufacture of the inventive sensor, the known sensor was heated to 140° C in a magnetic field for a short time, the field direction of said magnetic field had been rotated through 90 degrees about the normal to the substrate surface with respect to the field direction applied during the sputtering of the two ferromagnetic layers. By virtue thereof, it was attained that the anisotropy directions of the two ferromagnetic layers extended at an angle of approximately 90° with respect to each other.

Fig. 3-a shows the magnetoresistance curve of the above-described sensor in accordance with the state of the art. The resistance (R), being a function of the applied magnetic field (H), is determined in the range from -1.5 to +1.5 kA/m. Fig. 3-b shows the same curve measured with the above-described sensor in accordance with the invention. It can be calculated from the Figure that the magnetoresistance effect is approximately 9.4% per kA/m. The graphs also show that the hysteresis of the sensor in accordance with the invention is much smaller than the hysteresis of the known sensor. Moreover, the hysteresis curve of the inventive sensor has a much more regular trend than the curve of the known sensor.

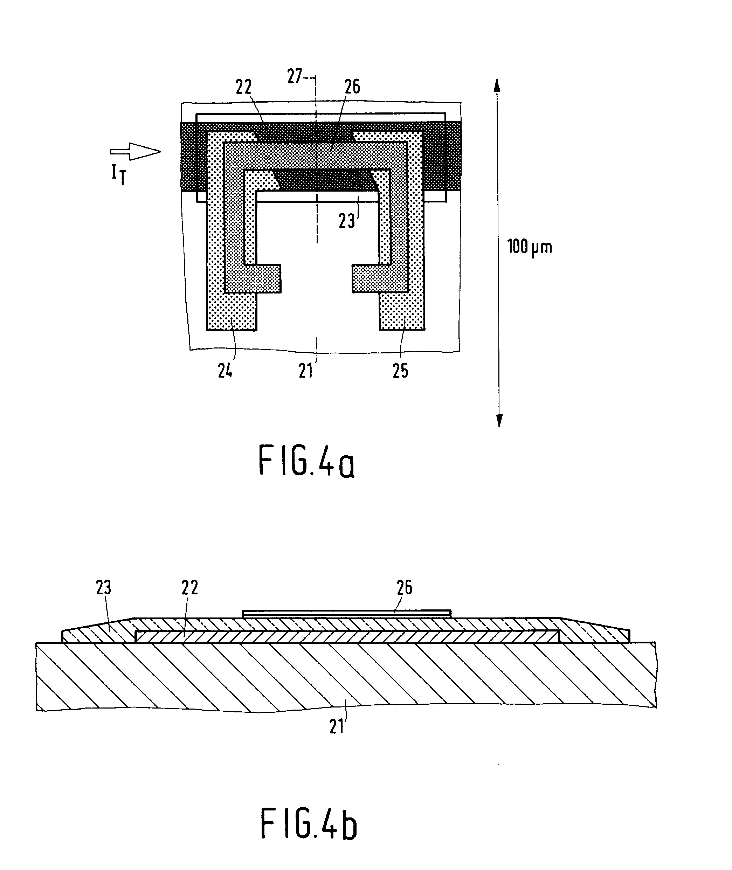

Fig. 4-a schematically renders a plan view of a microstructured experimental assembly with which the performance of a magnetic field sensor can be studied. A ferrite substrate 21 is provided with a single Au conductor strip 22. This strip 22 is blanketed by an insulating layer 23 of $SiO_2$, on which two flush Au electrical contact strips 24, 25 are provided. A multilayer magnetic field sensor 26 is deposited across the gap between the strips 24, 25. This multilayer 26 has the following nominal composition:

3 nm Ta/8 nm $Ni_{80}Fe_{20}$/2.5 nm Cu/6 nm $Ni_{80}Fe_{20}$/8 nm FeMn/3 nm Ta

whereby the order in which the layers are here listed is also the order in which they are deposited.

Fig. 4-b depicts an enlarged cross-section of the schematic experimental assembly depicted in Fig. 4-a, in which the said cross-section is made along the line 27. Identical parts in Figures 4-a and 4-b are denoted by the same reference numerals.

In experiments to determine the performance of the multilayer magnetic field sensor 26, a test electrical current $I_T$ is passed through the conductor strip 22. $I_T$ consists of a superimposed sinusoidal component of amplitude 2 mA RMS and frequency 520 Hz, and a constant bias component $I_B$. The presence of the oscillatory current $I_T$ induces an alternating magnetic field flux in the magnetic field sensor 26, the attendant electrical resistance variations therein constituting the experimental output and being measurable via the contact strips 24, 25. In general, this experimental output comprises a plurality of spectral harmonics, superimposed on a background noise level.

Embodiment 1 (not according to the invention)

The magnetic field sensor 26 was thus embodied that the direction of the magnet-crystalline anisotropy of its unbiased NiFe layer was parallel (or anti-parallel) to the direction of the exchange anisotropy of its biased NiFe layer, in accordance with the state of the art (see Figure 1). The spectral decomposition of the measured experimental output in this instance is rendered in Table I, wherein $h_n$ denotes the strength of the $n^{th}$ spectral harmonic relative to that of the first spectral harmonic, and N denotes the strength of the background noise relative to that of the first spectral harmonic, all such strengths being quoted in decibels (dB). The tabulated strengths are listed for three different values of the dc bias current $I_B$.

Table I

| $I_B$ (mA) | $h_2$ (dB) | $h_3$ (dB) | $h_4$ (dB) | $h_5$ (dB) | $h_6$ (dB) | N (dB) |
|---|---|---|---|---|---|---|
| 0 | -28 | -42 | -38 | -46 | -48 | -65 |
| 5 | -38 | -24 | -34 | -36 | -34 | -55 |
| 10 | -25 | -34 | -32 | -36 | -40 | -60 |

Embodiment 2 (according to the invention)

The magnetic field sensor 26 was in this case thus embodied that the direction of the magneto-crystalline anisotropy of its unbiased NiFe layer was transversely oriented (perpendicular) to the direction of the exchange anisotropy of its biased NiFe layer, in accordance with the invention (see Figure 2). The spectral decomposition of the measured experimental output in this case is compiled in Table II, where $h_n$

and N have the same meaning as in Table I.

Table II

| $I_B$ (mA) | $h_2$ (dB) | $h_3$ (dB) | $h_4$ (dB) | $h_5$ (dB) | $h_6$ (dB) | N (dB) |
|---|---|---|---|---|---|---|
| 0 | -25 | -40 | -54 | -48 | -54 | -75 |
| 5 | -48 | -63 | -52 | -54 | -54 | -75 |
| 10 | -33 | -46 | -50 | -54 | -50 | -75 |

In accordance with the insight on which the invention is based, the noise levels (N) in Table II are dramatically lower than those in Table I, together with the average strengths of the second and subsequent spectral harmonics ($h_n$).

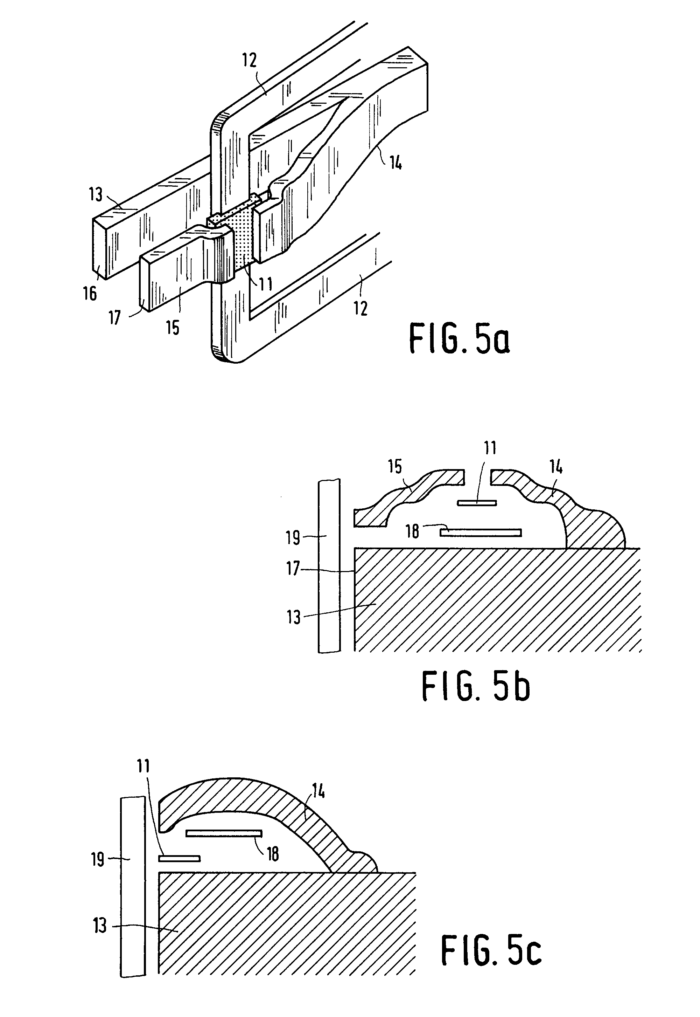

Fig. 5-a diagrammatically and perspectively shows a magnetic head comprising a sensor in accordance with the invention. Said magnetic head comprises a magnetic field sensor 11 having electrical connections 12. The head further comprises a magnetic substrate 13, for example of ferrite. This substrate may alternatively consist of a non-magnetic material on which a layer of magnetic material is deposited, for example NiFe. Said head further comprises flux guides 14, 15. The substrate, the flux guides and the sensor are positioned relative to each other in such a manner that they form a magnetic circuit. The end faces 16, 17 form part of the pole face of the magnetic head. The magnetic gap is located between said faces.

Fig. 5-b is a sectional view of the diagrammatically shown magnetic head of Fig. 5-a. Said sectional view is taken transversely to the end faces 16, 17. Identical parts of the Figures 5-a and 5-b bear the same reference numerals. Fig. 5-b also shows a current-carrying coil 18 which serves to adjust the magnetic field sensor.

The operation of the inventive magnetic head is explained by means of Fig. 5-b. If an information carrier 19, such as a magnetic tape, is caused to move past the pole face of the magnetic head, the magnetic tape generates a magnetic flux in the above-mentioned magnetic circuit by means of the information which is magnetically stored on said tape. Said magnetic flux is also fed through the magnetic field sensor. The flux changes are translated by the sensor into changes in the resistance of the sensor. Said change in resistance is converted into an electric signal which can be measured *via* the electrical connections 12.

The magnetic head in accordance with the invention, having the structure shown in Fig. 5-a and Fig. 5-b, is used only for reading magnetic information on a magnetic carrier. Fig. 5-c is a diagrammatic sectional view of another magnetic head having a sensor which, in addition to reading, can also be used for recording magnetic information on a magnetic tape. Identical parts of Figs. 5-a, b and c bear the same reference numerals. In the magnetic head of Fig. 5-c, the sensor 11 is not incorporated in the magnetic circuit which is formed by substrate 13 and flux guide 14. By virtue thereof, an electric signal in the coil 18 can also be used for recording on information carrier 19. As regards the read function of the magnetic head shown in Fig. 5-c, the magnetic circuit 13, 14 serves to protect the sensor 11.

## Claims

1.  A magnetic field sensor having a magnetoresistance element, comprising a substrate to which two ferromagnetic layers are applied which exhibit a uniaxial in-plane anisotropy and which are separated by a non-magnetic intermediate layer, characterized in that the anisotropy direction of one of the ferromagnetic layers is oriented transversely with respect to the anisotropy direction of the other ferromagnetic layer.

2.  A magnetic field sensor as claimed in Claim 1, characterized in that one ferromagnetic layer consists of NiFe and the other ferromagnetic layer consists of NiFe which is magnetically coupled to an anti-ferromagnetic layer.

3.  A magnetic field sensor as claimed in Claim 2, characterized in that the anti-ferromagnetic layer consists of FeMn.

4.  A magnetic field sensor as claimed in Claim 1, 2 or 3, characterized in that the intermediate layer consists of Cu or a Cu alloy.

5. A magnetic field sensor as claimed in any one of the preceding Claims, characterized in that the thickness of the ferromagnetic layers is 2.5-10 nm, preferably 4-9 nm, and that the thickness of the intermediate layer is 1.5-5 nm, preferably 2-3 nm.

6. A magnetic head comprising a magnetic field sensor as claimed in any one of the preceding Claims.

FIG.1a

FIG.1b

FIG.2a

FIG.2b

FIG.2c

FIG.3a

FIG.3b

$I_T$

27
22    26
23
24    21    25

100 μm

FIG.4a

23    22    26

21

FIG.4b

FIG. 5a

FIG. 5b

FIG. 5c